# EUROPÄISCHE PATENTSCHRIFT

(11) **EP 1 890 166 B1**
(45) Veröffentlichungstag und Bekanntmachung des Hinweises auf die Patenterteilung: **07.07.2010**
(21) Anmeldenummer: 07014020.7
(22) Anmeldetag: 17.07.2007
(51) Int. Cl.: G01R 31/28

(54) **Verfahren zur Analyse von Auswirkungen äusserer Einflüsse auf elektrische Schaltungen und Analysevorrichtung**
Method for analysing the effects of exterior influences on electric switches and analytic device
Procédé destiné à l'analyse des conséquences d'influences extérieures sur des circuits électriques et dispositif d'analyse

(30) Priorität: 16.08.2006 DE 102006038074; 08.11.2006 DE 102006052746
(43) Veröffentlichungstag der Anmeldung: 20.02.2008
(73) Patentinhaber: Rohde & Schwarz GmbH & Co. KG, 81671 München (DE)
(72) Erfinder: Reich, Friedrich, 86391 Stadtbergen (DE)
(74) Vertreter: Beder, Jens

(56) Entgegenhaltungen:
- DE-A1- 4 011 840
- US-A- 5 833 365
- US-A1- 2002 107 581
- US-A1- 2002 175 694
- US-A1- 2006 103 404

## Beschreibung

Die Erfindung betrifft ein Verfahren zur Analyse von Auswirkungen äußerer Einflüsse auf elektrische Schaltungen sowie eine entsprechende Analysevorrichtung.

Bei der Entwicklung von elektrischen oder elektronischen Schaltungen ist auch die Konstanz der Funktion der elektrischen Schaltung bei verschiedenen Einsatzbedingungen zu überprüfen. Hierzu muss das Verhalten eines Messwertes, beispielsweise einer Spannung am Ausgang der elektrischen Schaltung in Abhängigkeit von einem Umweltparameter überprüft werden. Ein typischer Umweltparameter, welcher einen Einfluss auf das Verhalten einer elektrischen Schaltung ausübt, ist die Temperatur oder der Druck. Um das temperaturbedingte Verhalten der elektrischen Schaltung zu analysieren wird daher üblicherweise die elektrische Schaltung auf eine vorgegebene Temperatur gebracht und bei dieser Temperatur ein charakteristischer Parameter der elektrischen Schaltung gemessen. Dies wird für mehrere Temperaturen wiederholt, so dass sich ein unmittelbarer Zusammenhang zwischen einer eingestellten Temperatur und dem korrespondierenden Messwert eines charakteristischen Parameters ergibt. Dieser Zusammenhang wird in einem zweidimensionalen Diagramm dargestellt, der folglich den Verlauf des Parameters über der Temperatur wiedergibt. In gleicher Weise kann für andere Umweltparameter wie den Druck vorgegangen werden.

Die beschriebene Vorgehensweise hat den Nachteil, dass ein unmittelbarer Zusammenhang zwischen dem Verlauf eines charakteristischen Parameters und dem Temperaturverlauf, dem das Bauteil ausgesetzt ist, dargestellt wird. Ein solcher Zusammenhang ist jedoch häufig nicht unmittelbar vorhanden. Durch Wärmeflüsse innerhalb von Bauteilen stellt sich so beispielsweise die Reaktion eines Bauteils der elektrischen Schaltung erst zeitversetzt zu dem Temperaturverlauf der Umgebung ein.

US 2006/0103404 offenbart ein Verfahren und ein System zur Analyse von Parametern elektrischer Komponenten unter verschiedenen thermischen Bedingungen. US 5,833,365 offenbart ein Verfahren und eine Vorrichtung zum Messen eines Parameters eines Prüflings bei einer gemessenen Temperatur.

Es ist daher die Aufgabe der Erfindung, eine verbesserte Analyse des Zusammenhangs zwischen Umwelteinflüssen und einen charakteristischen Parameter einer elektrischen Schaltung zu ermöglichen.

Die Aufgabe wird durch das erfindungsgemäße Verfahren nach Anspruch 1 sowie die erfindungsgemäße Analysevorrichtung nach Anspruch 13 gelöst.

Bei dem erfindungsgemäßen Verfahren wird eine elektrische Schaltung in einen Prüfraum gebracht. In dem Prüfraum wird ein vorgegebener äußerer Einfluss hergestellt. In diesem Prüfraum wird ein zeitlicher Verlauf eines ersten Parameters durch Erfassen von ersten Messwerten zu mehreren Zeitpunkten gemessen. Zusätzlich zu den ersten Messwerten eines ersten Parameters, welcher charakteristisch für eine bestimmte Eigenschaft der elektrischen Schaltung ist, wird auch der zeitliche Verlauf eines zweiten Parameters durch Erfassen von zweiten Messwerten zu mehreren Zeitpunkten gemessen, wobei dieser zweite Parameter einen äußeren Einfluss auf die elektrische Schaltung charakterisiert. Ein solcher Einfluss kann beispielsweise eine Umgebungstemperatur oder eine Umgebungsluftfeuchtigkeit sein.

Der zeitliche Verlauf des ersten Parameters wird in einem zweidimensionalen Diagramm ausgegeben, indem der Verlauf der ersten Messwerte als Funktion der Zeit aufgetragen wird. Zusätzlich wird in dem zweidimensionalen Diagramm der zeitliche Verlauf des zweiten Parameters, der den äußeren Einfluss charakterisiert, durch Kennzeichnung des Hintergrunds des Diagramms zu jedem dargestellten Zeitpunkt in Abhängigkeit von den zweiten Messwerten dargestellt.

Es wird somit einerseits in einem zweidimensionalen Diagramm, welches eine leichte Ablesbarkeit sicherstellt, der charakteristische Parameter der elektrischen Schaltung in Abhängigkeit von der Zeit dargestellt. Ebenfalls in Abhängigkeit von der Zeit wird zudem der Verlauf des zweiten, den äußeren Einfluss charakterisierenden Parameters dargestellt. Da beide Parameter, welche üblicherweise in einem unmittelbaren Zusammenhang angezeigt werden, erfindungsgemäß in Abhängigkeit vom zeitlichen Verlauf dargestellt werden, sind auch Verschiebungseffekte, die beispielsweise durch Wärmefluss in Bauteilen verursacht werden, aus dem zweidimensionalen Diagramm in einfacher Weise ablesbar.

Die erfindungsgemäße Analysevorrichtung weist hierzu einen Prüfraum und zumindest einen ersten Sensor zum Erfassen eines Messwerts des ersten Parameters sowie einen zweiten Sensor zum Erfassen eines zweiten, den äußeren Einfluss charakterisierenden Parameters auf. Ferner umfasst die Analysevorrichtung eine graphische Darstellungseinrichtung zur Darstellung eines zeitlichen Verlaufs der Messwerte des ersten Parameters und zur gleichzeitigen Ausgabe eines abhängig von dem Verlauf des zweiten Parameters gekennzeichneten Hintergrund des zweidimensionalen Diagramms. Die graphische Darstellungseinrichtung ist mit einem Messwerteausgabeabschnitt und mit einem Hintergrundausgabeabschnitt verbunden.

In den Unteransprüchen sind vorteilhafte Weiterbildungen des erfindungsgemäßen Verfahrens sowie der erfindungsgemäßen Analysevorrichtung ausgeführt.

Gemäß einer bevorzugten Ausführungsform werden die zweiten Messwerte des zweiten Parameters, die den Verlauf des äußeren Einflusses charakterisieren, als lokale Werte gemessen. Hierzu ist ein lokaler Sensor als zweiter Sensor an demjenigen Bauteil der elektrischen Schaltung angeordnet, dessen Verhalten durch Erfassen der ersten Messwerte analysiert wird. Die Anordnung des lokalen Sensors an dem Bauteil kann unmittelbar an dem Bauteil oder zumindest in der Nähe des Bauteils erfolgen. Bei Temperaturmessungen ist beispielsweise eine wärmeleitende Verbindung zwischen dem lokalen Sensor als zweiten Sensor und dem Bauteil der elektrischen Schaltung ideal. Auf diese Weise ergibt sich bei einer Messung ein unmittelbarer Zusammenhang beispielsweise zwischen der tatsächlichen Bauteiltemperatur und dem Verlauf der ersten Messwerte des ersten Parameters.

Weiterhin werden bevorzugt bei einer Erfassung von mehreren unterschiedlichen ersten Messwerten des ersten Parameters an unterschiedlichen Bauelementen für jedes dieser Bauelemente jeweils lokale Werte des zweiten Parameters erfasst. Hierzu ist jedes der Bauelemente, für die erste Messwerte erfasst werden, mit jeweils einem lokalen Sensor ausgerüstet, der an dem entsprechenden Bauelement angeordnet ist. Die zeitlichen Verläufe der ersten Messwerte des ersten Parameters und der lokalen Werte des zweiten Parameters werden in getrennten Diagrammen ausgegeben, so dass die unterschiedlichen zeitlichen Entwicklungen für jedes Bauelement separat dargestellt wird.

Weiterhin ist es vorteilhaft, zusätzlich zu den lokalen Werten des zweiten Parameters in dem Prüfraum, in dem die elektrische Schaltung angeordnet ist, eine Umgebungsgröße zu messen. Diese Umgebungsgröße gibt den primär vorgegebenen äußeren Einfluss wieder. In einem einfachen Beispiel ist dies die Umgebungstemperatur, die beispielsweise beim Einsatz von Kühlkörpern oder Lüftern nur mittelbar Einfluss auf die lokale Temperatur des zweiten Parameters an dem zu untersuchenden Bauelement hat.

Insbesondere wird es bevorzugt, den Hintergrund des Diagramms in jedem dargestellten Zeitpunkt farblich zu kennzeichnen. Die jeweils für den Zeitpunkt in dem Diagramm gewählte Farbe wird dabei in Abhängigkeit von den Messwerten des zweiten Parameters unterschiedlich gewählt. Alternativ hierzu oder in Ergänzung zur Wahl der unterschiedlichen Farben können auch unterschiedliche Helligkeiten zur Kennzeichnung des zeitlichen Verlaufs des zweiten Parameters durch den Hintergrund verwendet werden.

Weiterhin ist es vorteilhaft, zusätzlich zu der graphischen Ausgabe der Verläufe des ersten und des zweiten Parameters für einen ausgewählten Zeitpunkt in dem Diagramm zumindest den diesem Zeitpunkt zugeordneten Messwert des ersten Parameters und den zugeordneten zweiten Messwert des zweiten Parameters numerisch auszugeben.

Besonders vorteilhaft ist es, wenn aus den ersten Messwerten des ersten Parameters Wertebereiche ermittelt werden, welche zusätzlich zu den ersten Messwerten in dem zweidimensionalen Diagramm dargestellt werden. Dabei ist es insbesondere vorteilhaft, innerhalb der durch die Wertebereiche zu jedem Zweitpunkt definierten Flächenbereiche des Hintergrunds eine andere Kennzeichnung des Verlaufs des zweiten Parameters über die Zeit vorzunehmen, so dass sich der durch die jeweiligen Wertebereiche begrenzte Flächenbereich des Hintergrunds von dem restlichen Hintergrund abhebt. Dabei bleibt der zeitliche Verlauf des zweiten Parameters erkennbar.

Vorzugsweise wird dies für mehrere Flächenbereiche so durchgeführt, dass die Unterscheidung der durch die Wertebereiche definierten Flächenbereiche des Hintergrunds voneinander sowie von dem restlichen Hintergrund unterscheidbar sind. Innerhalb eines jeden Flächenbereichs des Hintergrunds bleibt dabei jeweils der Verlauf des zweiten Parameters über die Zeit erkennbar. Die zeitlichen Zusammenhänge und somit auch der indirekte Einfluss beispielsweise eines Temperaturprofils sind somit auch bei der Darstellung nicht nur der ersten Messwerte des ersten Parameters, sondern auch daraus berechneter Wertebereiche einfach aus dem Diagramm erkennbar.

Vorzugsweise wird zur Berechnung der Wertebereiche eine Standardabweichung und/oder Minimal-Maximal-Wertepaare innerhalb eines Intervalls berechnet. Dieses Intervall ist insbesondere bevorzugt gleich demjenigen Intervall, welches zur Bildung eines Mittelwertes der Messwerte des ersten Parameters über die Zeit verwendet wird, wobei diese Mittelwerte aufeinander folgender Intervalle, die sich auch teilweise überlappen können zur Erzeugung des Diagramms verwendet werden.

Ein bevorzugtes Ausführungsbeispiel ist in der Zeichnung dargestellt und wird in der nachfolgenden Beschreibung detailliert erläutert. Es zeigen:
- Fig. 1: ein Blockschaltbild eines ersten Ausführungsbeispiels einer erfindungsgemäßen Analysevorrichtung;
- Fig. 2: ein Beispiel für eine graphische Ausgabe des Verlaufs des ersten und zweiten Parameters auf einer Darstellungseinrichtung der erfindungsgemäßen Analysevorrichtung;
- Fig. 3: eine Darstellung zum Ablauf des erfindungsgemäßen Verfahrens; und
- Fig. 4: ein Blockschaltbild eines zweiten Ausführungsbeispiels einer erfindungsgemäßen Analysevorrichtung.

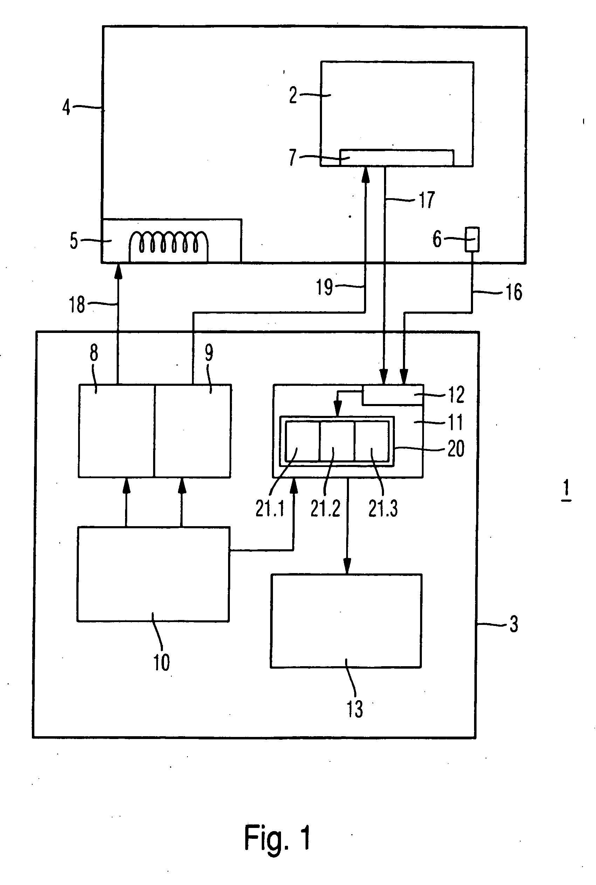

In der Fig. 1 ist ein Blockschaltbild einer erfindungsgemäßen Analysevorrichtung 1 gemäß eines ersten Ausführungsbeispiels dargestellt. Die erfindungsgemäße Analysevorrichtung 1 ist zur Analyse einer Auswirkung eines äußeren Einflusses auf eine elektrische Schaltung 2 vorgesehen. Die elektrische Schaltung 2 steht dabei stellvertretend für eine beliebige elektrische oder elektronische Baugruppe oder Baueinheit, welche in Abhängigkeit von äußeren Einflüssen ihre Eigenschaften ändert. Solche äußeren Einflüsse können beispielsweise die Temperatur, eine Umgebungsluftfeuchtigkeit oder beispielsweise der Umgebungsluftdruck sein.

Zum gezielten Einstellen der äußeren Einflüsse sowie zur Aufnahme der Messwerte ist ein Messrechner 3 vorgesehen. Der Messrechner 3 steuert die äußeren Einflüsse, welche in einem Prüfraum 4 eingestellt werden, um die Eigenschaften der elektrischen Schaltung 2 zu untersuchen. Die elektrische Schaltung 2 wird zur Durchführung der Messung in dem Prüfraum 4 angeordnet. Der Prüfraum 4 ist vorzugsweise ein dicht abgeschlossener Bauraum. Ein solcher abgeschlossener Bauraum kann in Abhängigkeit von der Größe der zu untersuchenden elektrischen Schaltung 2 gewählt werden. Zur Einstellung der äußeren Einflüsse dient eine Klimatisierungsvorrichtung 5, welche in dem dargestellten Ausführungsbeispiel schematisch eine Heizwendel zum Einstellen einer Temperatur in dem Prüfraum 4 aufweist. Die Klimatisierungsvorrichtung 5 ist dabei stellvertretend für eine Vorrichtung zur Einstellung beliebiger äußerer Einflüsse dargestellt.

Um die tatsächlich in dem Prüfraum 4 eingestellten äußeren Einflüsse bei der Analyse im Zusammenhang mit einer charakteristischen Größe der Schaltung 2 auswerten zu können, ist ein Sensor 6 in dem Prüfraum 4 angeordnet. Der Sensor 6 liefert ein zu dem relevanten äußeren Einfluss korrespondierendes Signal über eine Sensorleitung 16 an den Messrechner 3.

Zur Einstellung bestimmter Betriebszustände der elektrischen Schaltung 2 sowie zur Messung zumindest eines ersten Messwerts des charakteristischen Parameters der elektrischen Schaltung 2 weist die elektrische Schaltung 2 eine Schnittstelle 7 auf. Die Schnittstelle 7 ist einerseits dazu vorgesehen, den Betriebszustand der elektrischen Schaltung 2 einstellende Parameter an die elektrische Schaltung 2 weiterzuleiten bzw. dort Einstellungen vorzunehmen. Andererseits ist die Schnittstelle 7 dazu vorgesehen, innerhalb der elektrischen Schaltung 2 durch einen ersten Sensor gemessene erste Messwerte auszugeben, die über eine Messleitung 17 ebenfalls dem Messrechner 3 zugeführt werden. So kann beispielsweise bei komplexeren elektrischen Schaltungen 2 auf in die elektrische Schaltung 2 integrierte erste Sensoren zurückgegriffen werden. Anstelle des Erfassens durch Auslesen der ersten Messwerte des ersten Parameters über die Schnittstelle 7 ist es ebenso möglich, separate erste Sensoren an der elektrischen Schaltung 2 anzuordnen. Statt der ersten Sensoren können beispielsweise auch Spannungsmessgeräte vorgesehen sein, um einen Spannungsabfall über bestimmten Bauelementen der elektrischen Schaltung zu erfassen.

Zur Einstellung eines Verlaufs des zweiten Parameters, also der klimatischen Verhältnisse innerhalb des Prüfraums 4 ist ein Klimasteuerabschnitt 8 in dem Messrechner 3 vorgesehen. Der Klimasteuerabschnitt 8 ist über eine Steuerleitung 18 mit der Klimatisierungsvorrichtung 5 verbunden. In dem dargestellten einfachen Ausführungsbeispiel, in dem innerhalb des Prüfraums 4 lediglich eine Temperatur entsprechend einem vorgegebenen Verlauf eingestellt werden soll, wird über die Steuerleitung 18 das Heizelement der Klimatisierungsvorrichtung 5 zum Erzeugen einer bestimmten Heizleistung angesteuert.

Zusätzlich zu dem Klimasteuerabschnitt 18 ist ein Steuerungsabschnitt 9 vorgesehen, welcher über eine Konfigurationsleitung 19 mit der Schnittstelle 7 der elektrischen Schaltung 2 verbunden ist. Die Konfigurationsleitung 19 überträgt Konfigurationssignale an die elektrische Schaltung 2. Daraufhin wird die elektrische Schaltung 2 in einen bestimmten Betriebszustand gebracht, in dem anschließend die Messungen durchgeführt werden.

Zur Eingabe der über den Klimasteuerabschnitt 8 und über den Steuerabschnitt 9 einzustellenden Werte ist eine Tastatur 10 vorgesehen, welche mit dem Klimasteuerabschnitt 8, dem Steuerungsabschnitt 9 sowie einem zentralen Rechenabschnitt 11 des Messrechners 3 verbunden ist. Der zentrale Rechenabschnitt 11 umfasst einen Speicherbereich 12, in dem in Abhängigkeit von dem jeweiligen Zeitpunkt die zu diesem Zeitpunkt gemessenen ersten bzw. zweiten Messwerte sowohl des äußeren Einflusses in den Prüfraum 4 als auch des Messwerts des ersten Parameters gespeichert werden. Der zentrale Rechenabschnitt 11 ist hierzu über eine Sensorleitung 16 sowie eine Messwertleitung 17 mit dem Sensor 6 bzw. der Schnittstelle 7 verbunden. Anstelle der Verbindung mit der Schnittstelle 7 kann in bereits erläuterter Weise die Messwertleitung 17 auch mit einem separatem ersten Sensor oder einem Spannungsmessgerät oder mit einem ähnlichen zur Erfassung des ersten Messwerts des ersten Parameters geeigneten Bauelement verbunden sein, wenn der erste Sensor nicht in die elektrische Schaltung 2 integriert ist.

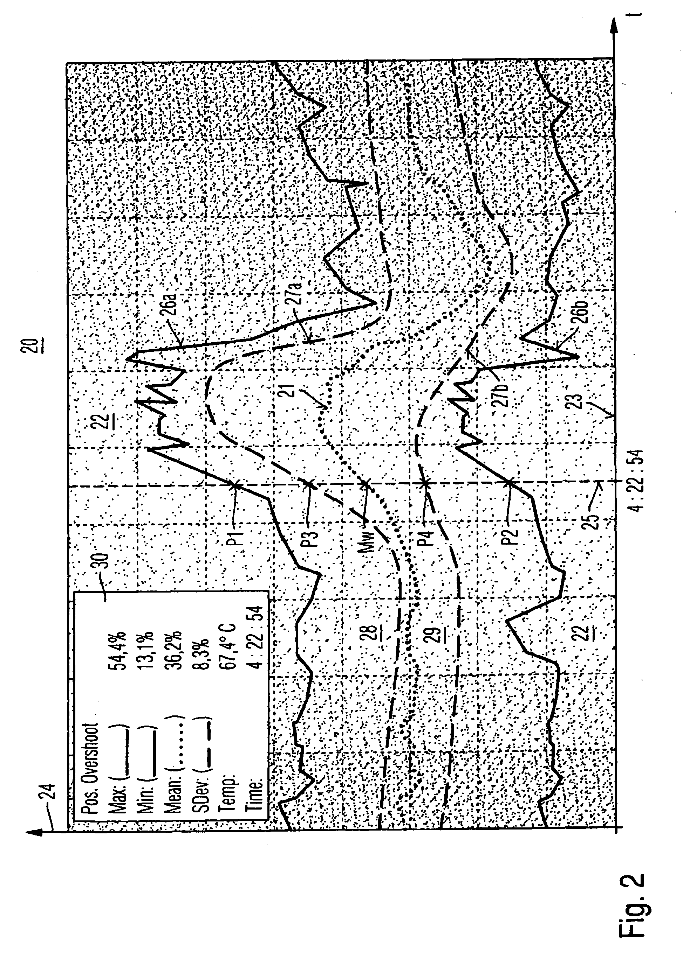

In dem Speicherbereich 12 des zentralen Rechenabschnitts 11 wird folglich in Abhängigkeit von einer Zeit jeweils ein erster Messwert für den ersten Parameter sowie ein zweiter Messwert für den zweiten Parameter, der den äußeren Einfluss in dem Prüfraum 4 charakterisiert, abgespeichert. Auf Basis dieser abgespeicherten Messwerte des ersten Parameters und des zweiten Parameters in Abhängigkeit von der Zeit wird durch den zentralen Rechenabschnitt 11 die Ausgabe in einem zweidimensionalen Diagramm auf einer Darstellungseinrichtung 13 vorbereitet. Zur Vorbereitung der Darstellung auf der Darstellungseinrichtung 13 weist der zentrale Rechenabschnitt 11 einen Messwertausgabeabschnitt 21.1, einen Hintergrundausgabeabschnitt 21.2 sowie einen Bereichsabschnitt 21.3 auf. Die Funktion der einzelnen Ausgabeabschnitte 21.1 bis 21.3 wird nachstehend unter Bezugnahme auf die Fig. 2 noch ausführlich erläutert.

Abgesehen von der Vorbereitung der in dem Speicherabschnitt 12 gespeicherten Daten wird durch den zentralen Rechenabschnitt 11 auch eine Weiterverarbeitung der ersten Messwerte des ersten Parameters durchgeführt. Aus den ersten Messwerten des ersten Parameters wird insbesondere ein Durchschnittswert, eine Standardabweichung sowie ein Maximal- und Minimalwert gebildet. Diese Werte werden für jeweils eine Gruppe von erfassten Messwerten berechnet. Über einen langen Messzeitraum wird eine Vielzahl von Messwerten des ersten und des zweiten Parameters berechnet. Um die Datenmenge zur Ausgabe des Verlaufs des ersten Parameters zu reduzieren, wird dabei jeweils ein Mittelwert aus einem Zeitintervall bzw. den darin enthaltenen Messwerten des ersten Parameters gebildet. Die Standardabweichung, sowie die Minimal- und Maximalwerte werden dann für dasselbe Intervall gebildet.

In dem ersten Ausführungsbeispiel sind also ein oder mehrere nicht dargestellte erste Sensoren und ein Sensor 6 als zweiter Sensor zur Erfassung der ersten Messwerte bzw. der zweiten, den äußeren Einfluss charakterisierenden Messwerte des zweiten Parameters vorgesehen.

Ein Beispiel für eine sich daraus ergebende Darstellung auf der Darstellungseinrichtung 13 ist in der Fig. 2 beispielhaft gezeigt. Die Fig. 2 zeigt ein zweidimensionales Diagramm, bei dem der Verlauf des ersten Parameters als erste Kurve 21 dargestellt ist. Die Ansteuerung der Darstellungseinrichtung 13 erfolgt durch den Messwertausgabeabschnitt 21.1. Die erste Kurve 21 ergibt sich durch das Auftragen einer Vielzahl von Mittelwerten von ersten Messwerten des ersten Parameters über der Zeit t. Die Mittelwerte werden jeweils aus den für ein bestimmtes Zeitintervall erfassten ersten Messwerten gebildet. Die Länge dieses Intervalls ist durch einen Bediener über die Tastatur 10 einstellbar. In dem dargestellten Ausführungsbeispiel ist das zweidimensionale Diagramm in kartesischen Koordinaten dargestellt, wobei die x-Achse 23 eine Zeitachse ist und die y-Achse 24 die Größe der ersten Messwerte des ersten Parameters bzw. der gebildeten Mittelwerte der ersten Messwerte des ersten Parameters angibt.

Um einen Bezug zu dem zeitlichen Verlauf des äußeren Einflusses zu erhalten, ist ein Hintergrund 22 des Diagramms 20 in Abhängigkeit von dem zu jedem Zeitpunkt gemessenen zweiten Messwert für den äußeren Einfluss gekennzeichnet. Diese Kennzeichnung kann beispielsweise in Form eines Farbverlaufs erfolgen, der durch Zuordnung von jeweils einem Farbwert zu einer Größe oder einem Größenbereich eines zweiten Messwerts erzeugt wird. In der Graustufendarstellung der Fig. 2 ist jedem in dem Diagramm 20 dargestellten Zeitpunkt, zu dem ein Mittelwert von mehreren erfassten ersten Messwerten des ersten Parameters dargestellt ist, ein zweiter Messwert zugeordnet. Auch der zweite Parameter kann durch Mittelwertbildung der tatsächlich zu jedem Zeitpunkt erfassten zweiten Messwerte wiedergegeben werden.

Zur Kennzeichnung des Verlaufs des zweiten Parameters ergeben sich somit Geradenabschnitte, welche parallel zu der y-Achse 24 verlaufen und die jeweils einen bestimmten Helligkeitswert oder Farbwert haben, der mit dem zweiten Messwert, bzw. dessen Mittelwert zu dem korrespondierenden Zeitpunkt entspricht. Dieser bestimmte Helligkeitswert (Farbwert) entspricht beispielsweise einer bestimmten Temperatur zu einem bestimmten Zeitpunkt. Ein solcher, ausgewählter Zeitpunkt wird durch die gestrichelte Linie 25 in dem Diagramm 20 dargestellt. Neben dem zu diesem Zeitpunkt existierenden Mittelwert Mw, der einen Mittelwert aus dem Verlauf des ersten Parameters wiedergibt, sind in dem Diagramm 20 weitere Informationen enthalten, die aus den ersten Messwerten berechnet werden.

Die Punkte P1 und P2 definieren beispielsweise einen Maximalwert (P1) sowie einen Minimalwert (P2) der ersten Messwerte innerhalb des Zeitintervalls, das der Bildung des Mittelwerts Mw zugrunde gelegt wird. Die tatsächlich erfassten ersten Messwerte in diesem Zeitintervall liegen sämtlich zwischen den Punkten P1 und P2. Die Verbindungslinie der Punkte P1 und P2 bildet einen Wertebereich zu einem bestimmten Zeitpunkt. Dieses Wertepaar P1, P2 definiert somit einen Bereich zu einem bestimmten Zeitpunkt. Für jedes Intervall, das in dem Diagramm 20 einem Zeitpunkt entspricht und zu dem ein Mittelwert Mw zur Darstellung des ersten Parameters in dem Diagramm 20 eingetragen wird, wird auch ein Wertepaar P1, P2 gebildet. Die Summe der Punkte P1 bildet dabei eine obere Einhüllende 26a. Entsprechend bildet die Summe der Punkte P2 die untere Einhüllende 26b. Zur besseren Analyse des Verhaltens der elektrischen Schaltungen 2 ist der Flächenbereich, der sich zwischen der oberen Einhüllenden 26a und der unteren Einhüllenden 26b als Summe aller Wertebereiche ergibt, unterscheidbar von dem restlichen Hintergrund dargestellt.

In der Fig. 2 ist dies durch den anderen Verlauf der Grauschattierungen in dem Flächenbereich 28, der durch die obere Einhüllende 26a und die untere Einhüllende 26b definiert wird, dargestellt. Innerhalb dieses Flächenbereichs 28 entspricht der Helligkeitsverlauf dabei wiederum dem Temperaturverlauf. Es wird also sowohl für den restlichen Hintergrund als auch für den Bereich 28 jeweils für jeden Zeitpunkt und den zu diesem Zeitpunkt erfassten zweiten Messwert des zweiten Parameters ein Helligkeitswert festgelegt, wobei die beiden Helligkeitswerte sich voneinander unterscheiden.

In dem dargestellten Ausführungsbeispiel wird durch das weitere Wertepaar P3, P4 ein weiterer Wertebereich des Messwerts 1 festgelegt. Die Summe dieser weiteren Wertebereiche bildet einen weiteren Flächenbereich 29, der sowohl gegenüber dem Flächenbereich 28 als auch dem Bereich des restlichen Hintergrunds in anderer Weise gekennzeichnet wird, wobei diese andere Kennzeichnung wiederum dem Verlauf des zweiten Parameters über die Zeit Rechnung trägt. Die Vorgehensweise ist dabei vergleichbar mit der in dem zweiten Flächenbereich 28.

Zur Kennzeichnung des Hintergrunds 22 und der Flächenbereiche 28, 29 in Abhängigkeit von dem zeitlichen Verlauf des zweiten Parameters werden die Messwerte des zweiten Parameters in Bezug zu den dargestellten Zeitpunkten gebracht und der Hintergrund entsprechend gekennzeichnet. Dies erfolgt für den Hintergrund in dem Hintergrundausgabeabschnitt 21.2. Für die Flächenbereiche 28, 29 erfolgt dies in jeweils einem weiteren Hintergrundausgabeabschnitt 21.3.

Wird zur Kennzeichnung des Verlaufs des zweiten Parameters anstelle eines Helligkeitsverlaufs ein Farbverlauf gewählt, so kann beispielsweise der weitere Flächenbereich 29 als Summe der in dem restlichen Hintergrund und dem Flächenbereich 28 gewählten Farbwerte zur Darstellung verwendet werden.

Die gestrichelte Linie 25 wird ebenfalls auf der Darstellungseinrichtung 13 angezeigt und ist durch eine Eingabevorrichtung in x-Richtung verschiebbar. Eine solche Eingabevorrichtung kann beispielsweise eine Computermaus sein, mit der die gestrichelte Linie 25 auf einem beliebigen Zeitpunkt einstellbar ist. Die diesem Zeitpunkt zugeordneten Werte für die Punkte P1, P2; P3, P4 und dem Mittelwert Mw werden in einem Fensterbereich 30 in tabellarischer Form numerisch dargestellt. Der Helligkeits- oder Farbverlauf, der den zeitlichen Verlauf des zweiten Parameters angibt, ist innerhalb des Fensterbereichs 30 ausgesetzt, so dass zur besseren Lesbarkeit in dem Fensterbereich 30 eine konstante Hintergrundsfarbe gewählt ist.

In dem dargestellten Ausführungsbeispiel sind sämtliche, aus den ersten Messwerten des ersten Parameters ermittelte Werte in einer ersten Farbe dargestellt. Unterscheidbar hiervon sind in einer zweiten Farbe die Bezugswerte für die Zeit t (Time) sowie den äußeren Einfluss (Temp) angegeben. In dem dargestellten Ausführungsbeispiel ist der äußere Einfluss eine Temperatur, wobei zu dem dargestellten Zeitpunkt (4:22:54) eine Umgebungstemperatur von 67,4°C in dem Prüfraum 4 geherrscht hat.

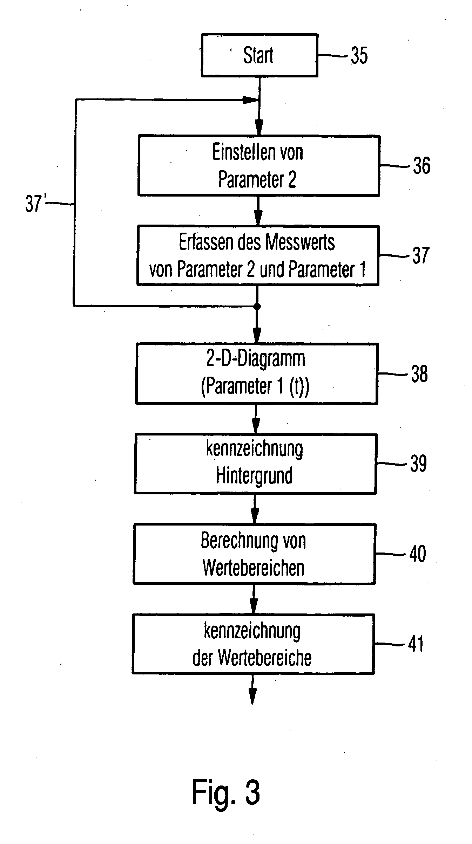

In der Fig. 3 ist noch einmal der Ablauf des erfindungsgemäßen Verfahrens vereinfacht dargestellt. Die Analyse einer elektrischen Schaltung 2 wird in Schritt 35 gestartet. In Schritt 36 werden die über die Tastatur 10 eingegebenen Parameter sowohl an den Klimasteuerabschnitt 8, den Steuerabschnitt 9 als auch den zentralen Rechenabschnitt 11 weitergegeben. Der über den Klimasteuerabschnitt 8 an die Klimatisierungsvorrichtung 5 weitergegebene Wert wird in dem Prüfraum 4 durch entsprechende Ansteuerung der Klimatisierungsvorrichtung 5 durch den Klimasteuerabschnitt 8 eingestellt. In Schritt 37 wird anschließend ein erster Messwert sowohl für den ersten Parameter als auch ein Messwert für den zweiten Parameter in Abhängigkeit von der Zeit erfasst. Die Wiederholung der Erfassung ersten und der zweiten Messwerte zu mehreren Zeitpunkten ist in der Fig. 3 durch den Schritt 37' verdeutlicht. Nach dem Erfassen des ersten Messwerts des ersten Parameters sowie zum gleichen Zeitpunkt des zweiten Messwerts des zweiten Parameters wird der äußere Einfluss entsprechend einem einstellbaren Verlauf angepasst. Für den neu eingestellten Parameter werden anschließend wieder die Messwerte durch den Sensor 6 und über die Schnittstelle 7 erfasst. Die Schritte 36 und 37 werden dabei solange wiederholt, bis beispielsweise ein vorgegebenes Temperaturprofil durchlaufen ist.

Anschließend werden in Schritt 38 die ersten bzw. aus den ersten Messwerten gebildete Mittelwerte in einem zweidimensionalen Diagramm als Funktion der Zeit t aufgetragen. Zudem wird in Schritt 39 der Hintergrund in Abhängigkeit von dem jeweils gemessenen zweiten Messwert gekennzeichnet.

Sofern zusätzliche Angaben in dem Diagramm dargestellt werden sollen, werden zunächst Wertebereiche, die durch Wertepaare definiert werden, berechnet (Schnitt 40). Diese Wertebereiche werden schließlich von dem Hintergrund 22 unterscheidbar gekennzeichnet (Schnitt 41), wobei innerhalb so begrenzter Flächenbereiche die zweiten Messwerte des zweiten Parameters gekennzeichnet werden.

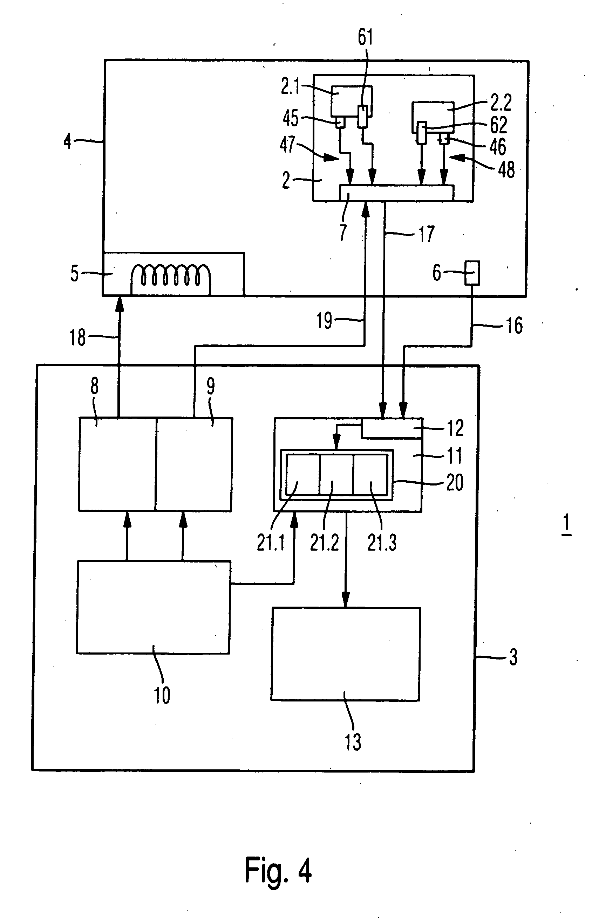

In der Fig. 4 ist ein zweites Ausführungsbeispiel einer erfindungsgemäßen Analysevorrichtung dargestellt. Die mit dem ersten Ausführungsbeispiel übereinstimmenden Elemente sind mit übereinstimmenden Bezugszeichen versehen, so dass auf eine erneute ausführliche Beschreibung verzichtet wird. Im Unterschied zu dem ersten Ausführungsbeispiel, dessen Aufbau in der Fig. 1 dargestellt ist, wird bei dem zweiten Ausführungsbeispiel ein lokaler Wert als Messwert für den zweiten Parameter in der elektrischen Schaltung 2 erfasst.

In dem dargestellten Ausführungsbeispiel sind exemplarisch ein erstes Bauelement 2.1 und zweites Bauelement 2.2 der elektrischen Schaltung 2 dargestellt. Die Bauelemente 2.1 und 2.2 können beispielsweise Mikroprozessoren sein, welche auf einer gemeinsamen, gedruckten Leiterplatte der elektrischen Schaltung 2 angeordnet sind. Aufgrund ihrer Anordnung innerhalb der gesamten Baugruppe, die beispielhaft als elektrische Schaltung 2 bezeichnet wird, kann der durch die Klimatisierungsvorrichtung 5 erzeugte äußere Einfluss sich unterschiedlich auf die Bauelemente 2.1 und 2.2 auswirken. Beispielsweise kann die gesamte elektrische Schaltung 2 einen Lüfter oder andere zur Kühlung vorgesehene Elemente aufweisen, so dass sich die sich einstellenden Temperaturen in den Bauelementen 2.1 und 2.2 voneinander unterscheiden. Um dennoch einen exakten Zusammenhang zwischen der jeweiligen Bauteiltemperatur und dem Verlauf des ersten Parameters erfassen zu können, ist an jedem der Bauelemente 2.1 und 2.2 ein lokaler Sensor 61 bzw. 62 angeordnet. Im Falle einer Temperaturmessung kann beispielsweise ein Temperaturfühler mit einer Wärmeleitpaste auf dem Mikroprozessor fixiert sein.

Die ersten Sensoren zur Erfassung der ersten Messwerte sind in der Fig. 4 mit 45 und 46 bezeichnet. Sowohl die ersten Sensoren 45, 46, die zum Erfassen der ersten Messwerte des ersten Parameters des ersten Bauelements 2.1 bzw. den ersten Messwerten des ersten Parameters des zweiten Bauelements 2.2 vorgesehen sind, als auch die lokalen Sensoren 61 bzw. 62 sind über Messleitungen 47 bzw. 48 mit der Schnittstelle 7 verbunden.

Im Falle der Durchführung einer Messung durch die Erfassung von zwei ersten Messwerten des ersten Parameters an unterschiedlichen Bauelementen der elektrischen Schaltung 2 werden jeweils eigenen Diagramme für die ersten Parameter der Bauelement 2.1, 2.2 ausgegeben, wie sie für eine Einzelmessung bereits unter Bezugnahme auf die Fig. 2 erläutert worden waren.

Zusätzlich kann durch den Sensor 6, der dann als zusätzlicher Sensor innerhalb des Prüfraums 4 angeordnet ist, eine Umgebungsgröße erfasst werden. Durch die zusätzliche Erfassung der Umgebungsgröße mittels des Sensors 6 als zusätzlichem Sensor kann auch der zeitliche Zusammenhang zwischen dem Verlauf der Umgebungsgröße und dem lokalen Wert des zweiten Parameters an den Bauelementen 2.1 und 2.2 erfasst werden. Hierzu wird beispielsweise der Verlauf der Umgebungsgröße, die durch den zusätzlichen Sensor 6 gemessen wird, zusätzlich in dem Diagramm eingetragen.

Neben der manuellen Markierung eines Zeitpunkts in dem Diagramm oder den Diagrammen ist es auch möglich, automatisch in jedem Diagramm oder einem Teil davon zumindest einen bestimmten Zeitpunkt zu markieren und die zugehörigen Messwerte auszugeben. Zur Festlegung solcher Zeitpunkte kann beispielsweise bei der Erfassung von mehreren ersten Messwerten mehrerer erster Parameter ein Grenzwert festgelegt werden. Wird beispielsweise eine Messung jeweils eines ersten Parameters an dem ersten Bauelement 2.1 und dem zweiten Bauelement 2.2 durchgeführt, so kann bei Erreichen eines Grenzwerts für den Verlauf des ersten Parameters des zweiten Bauelements 2.2 durch den ersten Messwert in dem zu dem ersten Bauelement 2.1 gehörigen Diagramm der korrespondierende Zeitpunkt automatisch markiert werden und die diesem Zeitpunkt zugeordneten ersten und zweiten Messwerte ersten Bauelements 2.1 ausgegeben werden.

Die Erfindung ist nicht auf die dargestellten Ausführungsbeispiele beschränkt. Der Schutzbereich der Erfindung ist durch die Ansprüche definiert.

## Patentansprüche

1. Verfahren zur Analyse der Auswirkung äußerer Einflüsse auf elektrische Schaltungen mit folgenden Verfahrensschritten:
- Anordnen einer elektrischen Schaltung (2) in einem Prüfraum (4),
- Erzeugen eines definierten äußeren Einflusses (36),
- Messen eines zeitlichen Verlaufs eines ersten Parameters, der das Verhalten der elektrischen Schaltung (2) charakterisiert, durch Erfassen von ersten Messwerten zu mehreren Zeitpunkten (37),
- Messen eines zeitlichen Verlaufs eines zweiten Parameters, der den äußeren Einfluss charakterisiert, durch Erfassen von zweiten Messwerten zu mehreren Zeitpunkten (37),
**gekennzeichnet durch folgende Verfahrensschritte:**
- Ausgeben des zeitlichen Verlaufs des ersten Parameters in einem zweidimensionalen Diagramm (38), in dem der zeitliche Verlauf des ersten Parameters als Funktion der Zeit aufgetragen wird,
- Ausgeben des zeitlichen Verlaufs des zweiten Parameters in dem zweidimensionalen Diagramm (38), in dem der zeitliche Verlauf des zweiten Parameters als Funktion der Zeit als Hintergrund (22) des Diagramms aufgetragen wird.

2. Verfahren nach Anspruch 1,
**dadurch gekennzeichnet,**
**dass** der zweite Parameter als lokaler Wert gemessen wird, wobei zur Erfassung der zweiten Messwerte ein Sensor (45, 46) an einem Bauteil (2.1, 2.2) der elektrischen Schaltung (2) angeordnet ist, an dem die ersten Messwerte des ersten Parameters erfasst werden.

3. Verfahren nach Anspruch 2,
**dadurch gekennzeichnet,**
**dass** bei einer Erfassung von ersten Messwerten erster Parameter an unterschiedlichen Bauelementen (2.1, 2.2) jeweils lokale Werte des zweiten Parameters erfasst werden und für jeden zeitlichen Verlauf der ersten Parameter ein separates Diagramm (20) ausgegeben wird.

4. Verfahren nach Anspruch 2 oder 3,
**dadurch gekennzeichnet,**
**dass** zusätzlich zu dem lokalen Wert des zweiten Parameters eine Umgebungsgröße in dem Prüfraum (4) gemessen wird.

5. Verfahren nach Anspruch 4,
**dadurch gekennzeichnet,**
**dass** die zusätzliche Umgebungsgröße als zusätzliche Messkurve in dem (den) Diagramm(en) ausgegeben wird.

6. Verfahren nach einem der Ansprüche 1 bis 5,
**dadurch gekennzeichnet,**
**dass** der Hintergrund (22) des Diagramms (20) für jeden dargestellten Zeitpunkt in Abhängigkeit von den zweiten Messwerten des zweiten Parameters mit unterschiedlichen Farben und /oder unterschiedlichen Helligkeiten **gekennzeichnet** wird.

7. Verfahren nach einem der Ansprüche 1 bis 6,
**dadurch gekennzeichnet,**
**dass** für einen ausgewählten Zeitpunkt in dem Diagramm (20) zumindest der zugeordnete erste Messwert des ersten Parameters und der zugeordnete zweite Messwert des zweiten Parameters numerisch ausgegeben wird.

8. Verfahren nach einem der Ansprüche 1 bis 7,
**dadurch gekennzeichnet,**
**dass** weitere, aus den ersten Messwerten berechneten Wertebereiche in dem Diagramm (20) dargestellt werden.

9. Verfahren nach einem der Ansprüche 1 bis 8,
**dadurch gekennzeichnet,**
**dass** aus den ersten Messwerten des ersten Parameters für jeden dargestellten Zeitpunkt zumindest ein Wertebereich berechnet wird und der jedem Zeitpunkt zugeordnete Wertebereich in einer gegenüber restlichen Hintergrund (22) in anderer Weise **gekennzeichnet** wird, wobei der zeitliche Verlauf des zweiten Parameters innerhalb eines durch den Wertebereich festgelegten Flächenbereichs (28) des Hintergrunds (22) **gekennzeichnet** wird, indem die Kennzeichnung des Wertebereichs ebenfalls in Abhängigkeit von den zweiten Messwerten des zweiten Parameters erfolgt.

10. Verfahren nach Anspruch 9,
**dadurch gekennzeichnet,**
**dass** bei mehreren Flächenbereichen (28, 29) mehrere voneinander und von dem restlichen Hintergrund (22) unterscheidbare Kennzeichnungen in durch die Wertebereiche definierten Flächenbereiche (28, 29) des Hintergrunds (22) verwendet werden, wobei sämtliche Flächenbereiche (28, 29) in Abhängigkeit von den zweiten Messwerten **gekennzeichnet** sind.

11. Verfahren nach Anspruch 9 oder 10,
**dadurch gekennzeichnet,**
**dass** zur Berechnung der Wertebereiche eine Standardabweichung und/oder Minimal-Maximal-Wertepaare innerhalb eines Intervalls berechnet werden.

12. Verfahren nach einem der Ansprüche 1 bis 10,
**dadurch gekennzeichnet,**
**dass** mehrere erste Messwerte erster Parameter an unterschiedlichen Bauteilen erfasst werden und in zumindest einem der zugeordneten Diagramme ein Zeitpunkt automatisch markiert wird, zu dem ein Grenzwert in einem der Verläufe der ersten Messwerte der ersten Parameter erreicht wird.

13. Analysevorrichtung zur Erzeugung eines definierten äußeren Einflusses (36) und zur Analyse der Auswirkung des äußeren Einflusses (36) auf elektrische Schaltungen (2) für elektrische Schaltungen (2) mit einem Prüfraum (4), zumindest einem ersten Sensor zum Erfassen eines ersten Messwerts eines ersten Parameters der elektrischen Schaltung (2) und zumindest einem zweiten Sensor (6, 61, 62) zur Erfassung eines zweiten Messwerts eines zweiten Parameters und einer grafischen Darstellungseinrichtung (13)
**dadurch gekennzeichnet,**
**dass** die grafische Darstellungseinrichtung (13) zur Darstellung eines zeitlichen Verlaufs der ersten Messwerte des ersten Parameters als Funktion der Zeit und zur gleichzeitigen Darstellung eines zeitlichen Verlaufs der zweiten Messwerte des zweiten Parameters als Hintergrund (22) des Diagramms (20) als Funktion der Zeit ausgebildet ist,
wobei die grafische Darstellungseinrichtung (13) mit einem Messwerteausgabeabschnitt (21.1) und einem Hintergrundausgabeasbchnitt (21.2, 21.3) verbunden ist.

14. Analysevorrichtung nach Anspruch 13,
**dadurch gekennzeichnet,**
**dass** ein lokaler Sensor (61, 62) als zweiter Sensor zum Erfassen eines lokalen Werts des zweiten Parameters an einem Bauteil (2.1, 2.2) der elektrischen Schaltung (2) angeordnet ist, an dem die ersten Messwerte erfasst werden.

15. Analysevorrichtung nach Anspruch 14,
**dadurch gekennzeichnet,**
**dass** ein zusätzlicher Sensor (6) zur Messung einer Umgebungsgröße in dem Prüfraum (4) angeordnet ist.

16. Analysevorrichtung nach einem der Ansprüche 1 bis 15,
**dadurch gekennzeichnet,**
**dass** durch den Hintergrundausgabeabschnitt (21.2, 21.3) der Hintergrund (22) des Diagramms (20) auf der grafischen Darstellungseinrichtung (13) abhängig von den zweiten Messwerten zu jedem dargestellten Zeitpunkt mit unterschiedlichen Farben und/oder unterschiedlichen Helligkeiten darstellbar ist.

17. Analysevorrichtung nach einem der Ansprüche 12 bis 16,
**dadurch gekennzeichnet,**
**dass** in dem Diagramm (20) ein Zeitpunkt auswählbar ist und für diesen Zeitpunkt die ersten und die zweiten Messwerte des ersten Parameters und des zweiten Parameters numerisch ausgebbar sind.

18. Analysevorrichtung nach einem der Ansprüche 13 bis 15,
**dadurch gekennzeichnet,**
**dass** in dem Diagramm (20) zusätzlich zu dem Verlauf der ersten Messwerte (21) des ersten Parameters aus diesen Messwerten berechnete Wertebereiche darstellbar sind.

19. Analysevorrichtung nach Anspruch 18,
**dadurch gekennzeichnet,**
**dass** ein durch den/die Wertebereich/e festgelegter Flächenbereich (28, 29) des Hintergrunds (22) in Abhängigkeit von den zweiten Messwerten des zweiten Parameters im Vergleich zu dem restlichen Hintergrund anders **gekennzeichnet** darstellbar sind.

20. Analysevorrichtung nach Anspruch 16 oder 19,
**dadurch gekennzeichnet,**
**dass** mehrere, durch mehrere Wertebereiche festgelegte Flächenbereiche (28, 29) des Hintergrunds (22) voneinander und von den übrigen Hintergrund (22) unterscheidbar **gekennzeichnet** sind, wobei jeder Flächenbereich (28, 29) in Abhängigkeit von den zweiten Messwerten **gekennzeichnet** darstellbar ist.

21. Analysevorrichtung nach einem der Ansprüche 18 bis 20,
**dadurch gekennzeichnet,**
**dass** die Wertebereiche durch eine Standardabweichung und/oder ein Minimal- Maximal-Wertepaar begrenzt sind.

## Claims

1. A method for analysing the effect of external influences on electrical circuits with the following method steps:
- arrangement of an electrical circuit (2) in a test chamber (4),
- generation of a defined external influence (36),
- measurement of a time characteristic of a first parameter, which characterises the behaviour of the electrical circuit (2) by registering first measured values at several timing points (37),
- measurement of a time characteristic of a second parameter, which characterises the external influence, by registering second measured values at several timing points (37),
**characterised by** the following method steps:
- output of the time characteristic of the first parameter in a two-dimensional diagram (38), in which the time characteristic of the first parameter is plotted as a function of time,
- output of the time characteristic of the second parameter in the two-dimensional diagram (38), in which the time characteristic of the second parameter is plotted as a function of time as a background (22) of the diagram.

2. The method according to claim 1,
**characterised in that**
the second parameter is measured as a local value, wherein, in order to register the second measured values, a sensor (45, 46) is arranged on a component (2.1, 2.2) of the electrical circuit (2), on which the first measured values of the first parameter are registered.

3. The method according to claim 2,
**characterised in that**,
in the case of a registering of first measured values of first parameters on different components (2.1, 2.2), local values of the second parameter are registered in each case, and a separate diagram (20) is output for each time characteristic of the first parameter.

4. The method according to claim 2 or 3,
**characterised in that**,
in addition to the local value of the second parameter, an environmental value in the test chamber (4) is measured.

5. The method according to claim 4,
**characterised in that**
the additional environmental value is output as an additional measured curve in the diagram(s).

6. The method according to any one of claims 1 to 5,
**characterised in that**
the background (22) of the diagram (20) is marked with different colours and/or different brightnesses for every displayed timing point dependent upon the second measured values of the second parameter.

7. The method according to any one of claims 1 to 6,
**characterised in that,**
for a selected timing point in the diagram (20), at least the allocated first measured value of the first parameter and the allocated second measured value of the second parameter is output numerically.

8. The method according to any one of claims 1 to 7,
**characterised in that**
further value ranges calculated from the first measured values are displayed in the diagram (20).

9. The method according to any one of claims 1 to 8,
**characterised in that,**
from the first measured values of the first parameter, a value range is calculated for every displayed timing point, and the value range allocated to every timing point is marked in a different manner relative to the rest of the background (22), wherein the time characteristic of the second parameter is marked within a surface region (28) of the background (22) determined by the value range, **in that** the marking of the value range is also implemented dependent upon the second measured values of the second parameter.

10. The method according to claim 9,
**characterised in that,**
in the case of several surface regions (28, 29), several markings distinguishable from one another and from the rest of the background (22) are used in surface regions (28, 29) of the background (22) defined by the value ranges, wherein all surface regions (28, 29) are marked dependent upon the second measured values.

11. The method according to claim 9 or 10,
**characterised in that,**
in order to calculate the value ranges, a standard deviation and/or minimal-maximal value pairs are calculated within an interval.

12. The method according to any one of claims 1 to 10,
**characterised in that**
several first measured values of first parameters are registered on different components and, in at least one of the allocated diagrams, a timing point is automatically marked, at which a threshold value in one of the characteristics of the first measured values of the first parameter is reached.

13. An analysis device for generating a defined external influence (36) and for analysing the effect of the external influence (36) on electrical circuits (2) for electrical circuits (2) with a test chamber (4), at least one first sensor for registering a first measured value of a first parameter of the electrical circuit (2) and at least one second sensor (6, 61, 62) for registering a second measured value of a second parameter and a graphic display device (13),
**characterised in that**
the graphic display device (13) is designed for the display of a time characteristic of the first measured values of the first parameter as a function of time and for the simultaneous display of a time characteristic of the second measured values of the second parameter as a background (22) of the diagram (20) as a function of time, wherein the graphic display device (13) is connected to a measured-value output portion (21.1) and a background-output portion (21.2, 21.3).

14. The analysis device according to claim 13,
**characterised in that**
a local sensor (61, 62) as a second sensor for registering a local value of the second parameter is arranged on a component (2.1, 2.2) of the electrical circuit (2), on which the first measured values are registered.

15. The analysis device according to claim 14,
**characterised in that**
an additional sensor (6) for the measurement of an environmental value is arranged within the test chamber (4).

16. The analysis device according to any one of claims 1 to 15,
**characterised in that,**
through the background-output portion (21.2, 21.3), the background (22) of the diagram (20) can be displayed on the graphic display device (13) with different colours and/or different brightnesses dependent upon the second measured values at every displayed timing point.

17. The analysis device according to any one of claims 12 to 16,
**characterised in that**
a timing point can be selected in the diagram (20), and for this timing point, the first and the second measured values of the first parameter and of the second parameter can be output numerically.

18. The analysis device according to any one of claims 13 to 15,
**characterised in that,**
in addition to the characteristic of the first measured values (21) of the first parameter, value ranges calculated from these measured values can be displayed in the diagram (20).

19. The analysis device according to claim 18,
**characterised in that**
a surface region (28, 29) of the background (22) determined by the value range(s) can be displayed dependent upon the second measured values of the second parameter marked differently by comparison with the rest of the background.

20. The analysis device according to claim 16 or 19,
**characterised in that**
several surface regions (28, 29) of the background (22) are marked in a manner distinguishable from one another and from the rest of the background (22), wherein each surface region (28, 29) can be displayed marked dependent upon the second measured values.

21. The analysis device according to any one of claims 18 to 20,
**characterised in that**
the measured values are limited by a standard deviation and/or a minimal-maximal value pair.

## Revendications

1. Procédé d'analyse des conséquences d'influences extérieures sur des circuits électriques avec les étapes de procédé suivantes:
- agencement d'un circuit électrique (2) dans une enceinte de test (4),
- production d'une influence extérieure définie (36),
- mesure d'une courbe dans le temps d'un premier paramètre qui caractérise le comportement du circuit électrique (2), par la détection de premières valeurs de mesure à plusieurs instants (37),
- mesure d'une courbe dans le temps d'un deuxième paramètre qui caractérise l'influence extérieure, par la détection de deuxièmes valeurs de mesure à plusieurs instants (37),
**caractérisé par les étapes de procédé suivantes:**
- émission de la courbe dans le temps du premier paramètre dans un diagramme bidimensionnel (38) dans lequel la courbe dans le temps du premier paramètre est tracée en fonction du temps,
- émission de la courbe dans le temps du deuxième paramètre dans le diagramme bidimensionnel (38), dans lequel la courbe dans le temps du deuxième paramètre est tracée en fonction du temps comme arrière-plan (22) du diagramme.

2. Procédé selon la revendication 1,
**caractérisé en ce que**
le deuxième paramètre est mesuré comme valeur locale, où pour la détection des deuxièmes valeurs de mesure, un capteur (45, 46) est disposé à un composant (2.1, 2.2) du circuit électrique (2), auquel sont détectées les premières valeurs de mesure du premier paramètre.

3. Procédé selon la revendication 2,
**caractérisé en ce que**
lors d'une détection de premières valeurs de mesure de premiers paramètres à des composants différents (2.1, 2.2), respectivement des valeurs locales du deuxième paramètre sont détectées, et pour chaque courbe dans le temps des premiers paramètres, un diagramme séparé (20) est émis.

4. Procédé selon la revendication 2 ou 3,
**caractérisé en ce qu'**
en plus de la valeur locale du deuxième paramètre, une grandeur environnante est mesurée dans l'enceinte de test (4).

5. Procédé selon la revendication 4,
**caractérisé en ce que**
la grandeur environnante additionnelle est émise comme courbe de mesure additionnelle dans le (les) diagramme(s).

6. Procédé selon l'une des revendications 1 à 5,
**caractérisé en ce que**
l'arrière-plan (22) du diagramme (20) est **caractérisé** pour chaque instant représenté en fonction des deuxièmes valeurs de mesure du deuxième paramètre avec des couleurs différentes et/ou des luminosités différentes.

7. Procédé selon l'une des revendications 1 à 6,
**caractérisé en ce que**
pour un instant sélectionné dans le diagramme (20), au moins la première valeur de mesure associée du premier paramètre et la deuxième valeur de mesure associée du deuxième paramètre sont émises numériquement.

8. Procédé selon l'une des revendications 1 à 7,
**caractérisé en ce que**
d'autres zones de valeur calculées à partir des premières valeurs de mesure sont représentées dans le diagramme (20).

9. Procédé selon l'une des revendications 1 à 8,
**caractérisé en ce qu'**
à partir des premières valeurs de mesure du premier paramètre est calculée pour chaque instant représenté au moins une zone de valeur, et la zone de valeur associée à chaque instant est **caractérisée** d'une autre manière par rapport à l'arrière-plan restant (22), où la courbe dans le temps du deuxième paramètre est **caractérisée** à l'intérieur d'une zone de face (28) de l'arrière-plan (22) déterminée par la zone de valeur, **en ce que** la caractérisation de la zone de valeur a également lieu en fonction des deuxièmes valeurs de mesure du deuxième paramètre.

10. Procédé selon la revendication 9,
**caractérisé en ce que**
dans le cas de plusieurs zones de face (28, 29), plusieurs caractérisations pouvant être distinguées les unes des autres et de l'arrière-plan restant (22) sont utilisées dans les zones de face (28, 29) de l'arrière-plan (22) définies par les zones de valeur, où toutes les zones de face (28, 29) sont **caractérisées en** fonction des deuxièmes valeurs de mesure.

11. Procédé selon la revendication 9 ou 10,
**caractérisé en ce que**
pour le calcul des zones de valeur, un écart standard et/ou des paires de valeurs minimale-maximale sont calculés à l'intérieur d'un intervalle.

12. Procédé selon l'une des revendications 1 à 10,
**caractérisé en ce que**
plusieurs premières valeurs de mesure de premiers paramètres sont détectées à des composants différents, et dans au moins un des diagrammes associés, un instant est marqué automatiquement auquel une valeur limite est atteinte dans une des courbes des premières valeurs de mesure des premiers paramètres.

13. Dispositif d'analyse pour la production d'une influence extérieure définie (36) et pour l'analyse des conséquences de l'influence extérieure (36) sur des circuits électriques (2) pour des circuits électrique (2) avec une enceinte de test (4), au moins un premier capteur pour la détection d'une première valeur de mesure d'un premier paramètre du circuit électrique (2) et au moins un deuxième capteur (6, 61, 62) pour la détection d'une deuxième valeur de mesure d'un deuxième paramètre et une installation de représentation graphique (13),
**caractérisé en ce que**
l'installation de représentation graphique (13) est réalisée pour la représentation d'une courbe dans le temps des premières valeurs de mesure du premier paramètre en fonction du temps et pour la représentation simultanée d'une courbe dans le temps des deuxièmes valeurs de mesure du deuxième paramètre comme arrière-plan (22) du diagramme (20) en fonction du temps,
où l'installation de représentation graphique (13) est reliée à une section d'émission de valeurs de mesure (21.1) et une section d'émission d'arrière-plan (21.2, 21.3).

14. Dispositif d'analyse selon la revendication 13,
**caractérisé en ce qu'**
un capteur local (61, 62) est disposé comme deuxième capteur pour la détection d'une valeur locale du deuxième paramètre à un composant (2.1, 2.2) du circuit électrique (2) auquel sont détectées les premières valeurs de mesure.

15. Dispositif d'analyse selon la revendication 14,
**caractérisé en ce qu'**
un capteur additionnel (6) est disposé pour la mesure d'une grandeur environnante dans l'enceinte de test (4).

16. Dispositif d'analyse selon l'une des revendications 1 à 15,
**caractérisé en ce que**
par la section d'émission d'arrière-plan (21.2, 21.3), l'arrière-plan (22) du diagramme (20) peut être représenté sur l'installation de représentation graphique (13) en fonction des deuxièmes valeurs de mesure à chaque instant représenté en des couleurs différentes et/ou des luminosités différentes.

17. Dispositif d'analyse selon l'une des revendications 12 à 16,
**caractérisé en ce que**
dans le diagramme (20), un instant peut être sélectionné, et pour cet instant, les premières et les deuxièmes valeurs de mesure du premier paramètre et du deuxième paramètre peuvent être émises numériquement.

18. Dispositif d'analyse selon l'une des revendications 13 à 15,
**caractérisé en ce que**
dans le diagramme (20), en plus de la courbe des premières valeurs de mesure (21) du premier paramètre, des zones de valeur calculées à partir de ces valeurs de mesure peuvent être représentées.

19. Dispositif d'analyse selon la revendication 18,
**caractérisé en ce qu'**
une zone de face (28, 29) de l'arrière-plan (22) fixée par la/les zone/s de valeur peuvent être représentées en fonction des deuxièmes valeurs de mesure du deuxième paramètre en comparaison à l'arrière-plan restant en étant **caractérisées** autrement.

20. Dispositif d'analyse selon la revendication 16 ou 19,
**caractérisé en ce que**
plusieurs zones de face (28, 29) de l'arrière-plan (22) déterminées par plusieurs zones de valeur sont **caractérisées** pour qu'on puisse les distinguer les unes des autres et de l'arrière-plan restant (22), où chaque zone de face (28, 29) peut être représentée d'une manière **caractérisée en** fonction des deuxièmes valeurs de mesure.

21. Dispositif d'analyse selon l'une des revendications 18 à 20,
**caractérisé en ce que**
les zones de valeur sont limitées par un écart standard et/ou une paire de valeurs minimale-maximale.
